# EUROPEAN PATENT APPLICATION

(11) **EP 2 312 757 A1**
(43) Date of publication of application: **20.04.2011**
(21) Application number: 09305901.2
(22) Date of filing: 28.09.2009
(51) Int. Cl.: H03M 7/30

(54) **Method and apparatus for compressing XML documents**

(71) Applicant: Thomson Licensing, 92100 Boulogne-Billancourt (FR)
(72) Inventor: Song, Wen Juan, 92648 BOULOGNE cedex (FR); Zhou, Guang Hua, 92648 BOULOGNE cedex (FR); Chen, Ren Lei, 92648 BOULOGNE cedex (FR); Ma, Xiao Jun, 92648 BOULOGNE cedex (FR)
(74) Representative: Berthier, Karine

(57) **Abstract**

A method and apparatus for compressing XML documents is provided. The method comprises steps of: storing an extensible markup language schema document and associated extensible markup language fragments based on which the extensible markup language schema is compressed, and removing from the extensible markup language schema document of the definition of an element and/or an attribute based on the occurrence of the element in the associated extensible markup language fragments. The apparatus is corresponding to the method.

## Description

### TECHNICAL FIELD

This invention relates to document compression, especially to a method and apparatus for compressing XML documents.

### BACKGROUND OF THE INVENTION

XML (Extensible Markup Language) is developed by an XML Working Group in 1996. Since then this markup language is widely used. XML schema defines and describes a class of XML documents by using schema components to constrain and document the meaning, usage and relationships of their constituent parts: datatypes, elements and their content and attributes and their values. An XML element is what between the element's "start" tag and the element's corresponding "end" tag that uses a same name with the "start" tag. An element can contain other elements, simple text or both. In addition, XML elements can have attributes providing information about the elements. An attribute's value shall be enclosed either in single quotes or double one.

**Table-1**

| | |
|---|---|
| <person nationality="Britain"> | |
| | <firstname>Harry</firstname> |
| | <lastname>Porter</lastname> |
| </person> | |

Table1 describes an exemplary XML document, in which <person> is a start tag with </person> being the corresponding end tag, <firstname> is a start tag and </firstname> is the end tag, and <lastname> is a start tag with an end tag </lastname>. So there are three elements: "person", "firstname", "lastname". Further, "first name" and "last name" are sub-elements of the element "person". "Harry" and "Porter" are text contents. The element "person" also has an attribute (nationality="Britain").

Above Table1 only describes a very simple example of an XML document. Actually, in practice, an XML document is much more complicated and exquisite, which will cost quite a lot of network resources when transmitted over network or cost a significant amount of computer resources when stored in a computer. For example, in ESG (Electronic Service Guide) or EPG (Electronic Program Guide) systems, the XML schema usually defines much more optional attributes and elements than those used in the XML instance, for BiM encoding, and even absent attributes and elements still need bits "zero" to indicate their absence in the compressed bitstream. So it is desirable to reduce XML documents' size or compress XML documents.

Currently there are mainly three categories of XML compressing methods: redundancy-based, schema-based and hybrid. Redundancy-based compressing methods use the repetition of character groups within a source document. They work by removing redundancy at the character level. When a source document is compressed, it is assumed that there is no knowledge of the structure or contents of the source document, and the redundant character groups are replaced based on their statistical occurrence in the source document (e.g., Huffman encoding). In general, redundancy-based compressing methods can achieve good compressing results on large text documents but become less effective as the document size decreases. Schema-based compressing methods work by encoding a source document based on design knowledge of the permitted content and structure of the source document. In schema based compressing methods, the full XML tags are not represented in the compressed form and can be reconstructed using the design knowledge. The design knowledge is also leveraged to efficiently encode the data contents of the source document. Hybrid compressing methods apply a combination of redundancy-based and schema-based methods to the same source document.

### SUMMARY OF THE INVENTION

In an aspect, a method for compressing extensible markup language is provided, which comprises steps of: storing an extensible markup language schema document and associated extensible markup language fragments based on which the extensible markup language schema is compressed, and removing from the extensible markup language schema document of the definition of an element based on the occurrence of the element in the associated extensible markup language fragments.

In addition, the method further comprises a step of removing from the extensible markup language schema document of the definition of an attribute based on the occurrence of the attribute in the associated extensible markup language fragments.

Wherein, remove from the extensible markup language schema document of the definition of the element and the attribute when their occurrence frequencies in the associated extensible markup language fragments are less than a predetermined threshold.

Further, the related extensible markup language fragments constitute one or more documents.

Moreover, current method further comprises a step of labeling the compressed extensible markup language schema so that it can be recognized.

In a second aspect, an apparatus for compressing extensible markup language is recited, which comprises a means for storing an extensible markup language schema document and associated extensible markup language fragments based on which the extensible markup language schema is compressed, and a means for removing from the extensible markup language schema document of the definition of an element based on the occurrence of the element in the associated extensible markup language fragments.

In a variance, the means is also for removing from the extensible markup language schema document of the definition of an attribute based on the occurrence of the attribute in the associated extensible markup language fragments.

Further, the means removes from the extensible markup language schema document of the definition of the element and the attribute when their occurrence frequencies in the associated extensible markup language fragments are less than a predetermined threshold.

In the apparatus, the related extensible markup language fragments constitute one or more documents.

The apparatus further comprises a means for labeling the compressed extensible markup language schema so that it can be recognized.

### BRIEF DESCRIPTION OF THE DRAWINGS

The current principle will be better understood from the following detailed description when read in conjunction with the accompany drawings which are briefly described below:
FIG.1 shows an exemplary source XML schema where current XML document compressing method is used;
FIG.2 shows an associated reference XML fragment based on which the source XML schema in Fig.1 is compressed;
FIG.3 shows a resulting compressed XML schema of that in Fig.1.
FIG.4 shows another exemplary source XML schema where current XML document compressing method is used;
FIG.5 shows a first associated reference XML fragment used to compress the source XML schema in Fig.4;
FIG.6 shows a second associated reference XML fragment used to compress the XML schema in Fig.4;
FIG.7 shows a third associated reference XML fragment used to compress the XML schema in Fig.4;
FIG.8 shows a resulting compressed XML schema of that in Fig.4;
FIG.9 is a flow chart illustrating the process of current XML document compressing method;
FIG.10 is a diagram showing a detailed exemplary system structure using current inventive method.

### DETAILED DESCRIPTION OF IMPLEMENTATIONS

Methods for compressing XML documents containing XML schema based on analysis of a number of associated reference XML documents and/or fragments are elaborated. These methods are described in below embodiments to illustrate the current XML document compressing principle, and should not be construed as any limitation to the invention.

It is known that an XML schema describes the structure of an XML document. An XML fragment is a part of a completed XML document, and should be syntax completed. Hereafter methods are provided to compress XML documents containing XML schema consisting of attributes and elements by checking the occurrence frequency of each attribute and element in the associated reference XML documents and/or fragments.

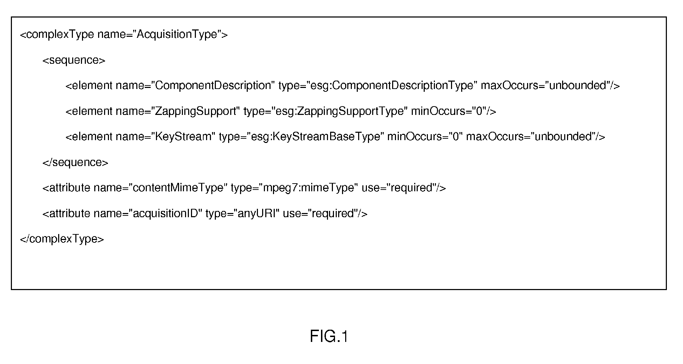

Fig.1, 2 and 3 illustrate a first embodiment using current XML document compressing method.

Fig.1 is an exemplary XML schema derived from Standard *"IP Datacast over DVB-H: Electronic Service Guide (ESG)"* and shows a definition of "Acquisition" element. Usually an XML schema defines two types of elements, simple type elements and complex type elements which are composed of attributes and sub-elements. In the schema of Fig.1, "Acquisition" element is a complex one and includes sub-elements: "ComponentDescription", "ZappingSupport", and "KeyStream" and attributes: "contentMimeType" and "acquisitionID".

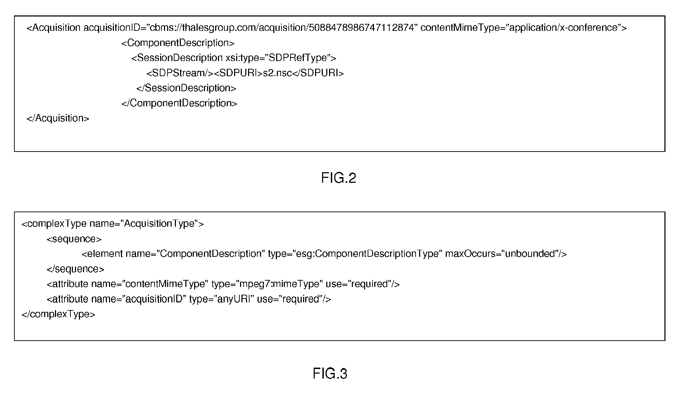

Fig.2 is an associated reference XML fragment of the "Acquisition" element. Based on this fragment, the XML schema shown in Fig.1 is compressed.

For an element or an attribute in the XML schema of Fig.1, count the occurrence it appears in the associated reference XML fragment of Fig.2 firstly. Afterwards, a determination criterion is set. For example, when the occurrence frequency of an element or an attribute in the associated reference XML fragment of Fig.2 is not larger than a threshold, e.g. "0", the element or the attribute will be removed from the schema shown in Fig.1; otherwise they will be kept in the schema.

According to above mentioned determination criterion, combining Fig.1 and Fig.2, it can be seen that the attributes: "ZappingSupport" and "KeyStream" are not depicted in Fig.2. While other elements and attributes at least appear once. So "ZappingSupport" and "KeyStream" are removed from the original XML schema shown in Fig.1 with the result being shown in Fig.3.

Though in above first embodiment, what shown in Fig.2 is an associated reference XML fragment, it can be deemed as an associated reference XML document containing only one XML fragment. So there is no distinct difference between an XML fragment and an XML document. It can be said that above compression is "document" based.

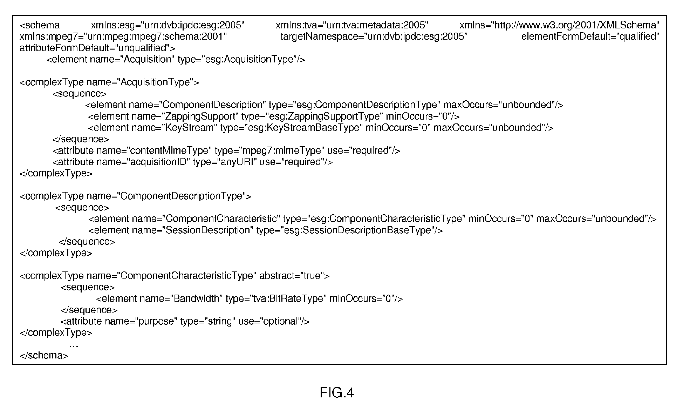

Referring now to Fig.4~Fig.8, a second illustrative embodiment using current XML compressing method will be provided.

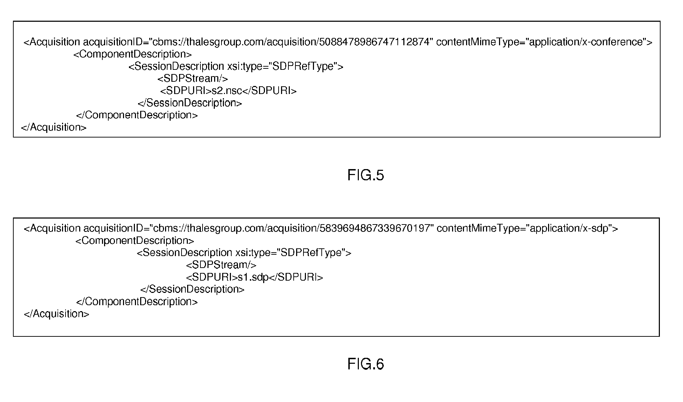

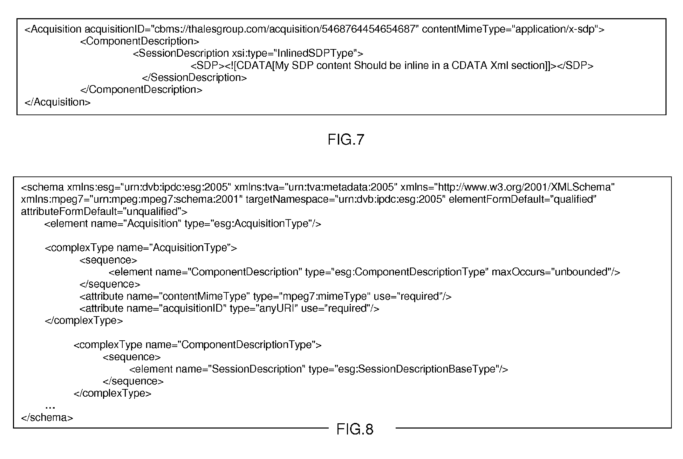

Fig.4 is an XML schema to be compressed, where there is a complex element "Acquisition" composed of sub-elements "ComponentDescription", "ZappingSupport" and "KeyStream", as well as the attributes "contentMimeType" and "acquisitionID", in which "ComponentDescription" is made of sub-elements "ComponentCharacteristic" and "SessionDescription", in which "ComponentCharacteristic" consists of sub-element "Bandwidth" and attribute "purpose". Fig.5~Fig.7 are three associated reference XML fragments used to make the statistic for the XML schema in Fig.4. And Fig.8 is a simplified XML schema of Fig.4 considering the associated reference XML fragments in Fig.5~Fig.7 as a base for the compression.

From the three associated reference XML fragments in Fig.5~Fig.7, we can get the statistic result of the occurrence frequencies of the elements and attributes in Fig.4:
"Acquisition" appears 3 times in the 3 associated reference XML fragments with the occurrence frequency being 1.
"ComponentDescription" shows up 3 times in the 3 associated reference XML fragments. The occurrence frequency is 1.
"ZappingSupport" is not shown in any of the 3 associated reference XML fragments. So the occurrence frequency is 0.
"KeyStream" doesn't show up either. And its occurrence frequency is 0.
"ComponentCharacteristic" doesn't appear in the 3 associated reference XML fragments. Its occurrence frequency is 0.
"SessionDescription" appears 3 times in the 3 associated reference XML fragments, with the occurrence frequency being 1.
For "Bandwidth", its occurrence frequency is 0.
For "contentMimeType", its occurrence frequency is 1 considering the 3 associated reference XML fragments.
"acquisitionlD" appears 3 times in the 3 associated reference XML fragments, with an occurrence frequency of 1.
"purpose" can't be found in the 3 associated reference XML fragments. So its occurrence frequency is 0.

Based on above statistic, we set a threshold "0" to make a criterion here. For the elements and attributes in the XML schema of Fig.4, if the occurrence frequency of an element or an attribute is larger than 0, it will be kept in the schema; otherwise it will be removed to simplify the schema.

Then the simplified schema is shown in Fig.8, from which it can be seen that the sub-elements "ZappingSupport" and "KeyStream" are removed from the definition of element "Acquisition". "ComponentCharacteristic" is removed from the definition of "ComponentCharacteristic". And the element "ComponentCharacteristic" together with its sub-element "Bandwidth" and attribute "purpose" is removed from the schema in Fig.4.

In this second embodiment, the 3 associated reference XML fragments in Fig.5~7 can be in one associated reference document or several associated reference documents. This embodiment is illustrated based on "fragment". In a variant embodiment, the XML schema in Fig.4 can be compressed based on "document". For instance, the 3 associated XML fragments of Fig.5~7 belong to an associated reference XML document. Then count the occurrence frequency that each element and attribute in Fig.4 appears in the associated reference XML document. The statistic result is:
"Acquisition" appears 3 times in the associated reference XML document with the occurrence frequency being 3.
"ComponentDescription" shows up 3 times in the associated reference XML document. The occurrence frequency is 3.
"ZappingSupport" is not shown in the associated reference XML document. Its occurrence frequency is 0. Same situation happens to "KeyStream", "ComponentCharacteristic", "Bandwidth", and "purpose". So their occurrence frequencies are 0 too.

According to the principle, it can be seen that the occurrence frequencies of "SessionDescription", "contentMimeType", and "acquisitionlD" are 3.

Then still a threshold "0" is defined as the determination criterion. The result is the same with that shown in Fig.8.

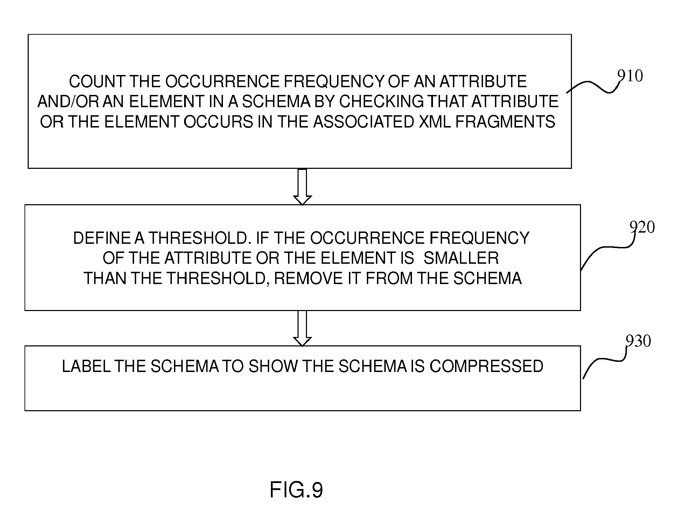

Fig.9 is a flow chart illustrating the process of current XML document compressing method.

At step 1, for each element in a schema, count the occurrence frequency of each attribute and sub-element which make of the element's definition in the schema by checking that element occurs in associated reference XML fragments.

At step 2, define a threshold of occurrence frequency for each element according to the statistic. For those attributes and elements whose occurrence frequencies are lower than the threshold, remove them from the element's definition in the schema.

At step 3, for the XML schema to be compressed, check whether it can be covered by the pruned schema. If yes, use the compressed schema, otherwise the original schema is used. And an identifier, e.g. one bit "1" or "0", is added at the beginning of the encoded bitstream to indicate whether the compressed schema is used ("1") or not ("0").

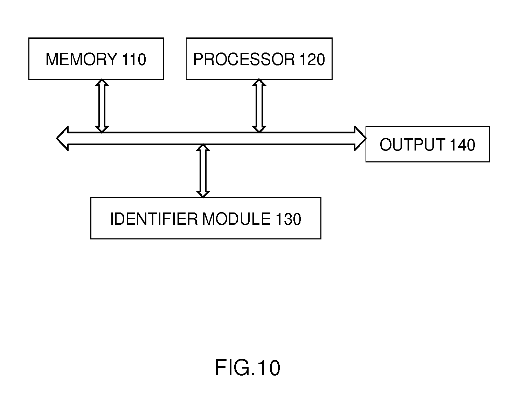

Current method for compressing XML documents can be applied to Mobile broadcast, DVB-C, DVB-T, IPTV systems etc. to compress the ESG and EPG. Also, current method can be used in other scenarios where XML documents are needed to be compressed. Basically, for example, referring to Fig.10, it is a diagram showing a detailed exemplary system structure using current inventive method. In above systems, memory 110 is used to store an XML document before and after the compression, as well as the associated reference XML fragments based on which the XML document is compressed. In particular, the XML document to be compressed is an XML schema document, and the associated reference XML fragments constitute one or more documents. A processor 120 is needed to compress the XML document based on the associated reference XML fragments. To be more specific, the processor 120 removes elements and attributes whose occurrence frequencies in the associated reference XML fragments are less than a threshold. The occurrence frequencies are counted for example based on the number of the associated reference XML fragments or just based on the occurrence time that an element or an attribute appears in the associated reference XML fragments. An identifier module 130 is used for labeling the compressed XML document with for example "0" or "1" so that the compressed XML document can be easily recognized. An output interface 140 is applied to output the compressed XML document over the internet or other devices for further process.

It is to be understood that though in above methods and apparatuses for compressing XML fragments/ documents, both XML element and attribute are used to illustrate current principle, current principle can be applied to either of them or their equivalences, which should be in the coverage of current invention.

Although the illustrative embodiments have been described herein with reference to the accompanying drawings, it is to be understood that the present invention is not limited to those precise embodiments, and that various changes and modifications may be effected therein by one of ordinary skill in the pertinent art without departing from the scope or spirit of the present invention. All such changes and modifications are intended to be included within the scope of the present invention as set forth in the appended claim.

## Claims

1. A method for compressing extensible markup language, comprising steps of:
storing an extensible markup language schema document and associated extensible markup language fragments based on which the extensible markup language schema is compressed, and
removing from the extensible markup language schema document of the definition of an element based on the occurrence of the element in the associated extensible markup language fragments.

2. The method for compressing extensible markup language according to claim 1, wherein it further comprises a step of removing from the extensible markup language schema document of the definition of an attribute based on the occurrence of the attribute in the associated extensible markup language fragments.

3. The method for compressing extensible markup language according to claim 2, wherein removing from the extensible markup language schema document of the definition of the element and the attribute when their occurrence frequencies in the associated extensible markup language fragments are less than a predetermined threshold.

4. The method for compressing extensible markup language according to claim 3, wherein the related extensible markup language fragments constitute one or more documents.

5. The method for compressing extensible markup language according to claim 4, wherein it further comprises a step of labeling the compressed extensible markup language schema so that it can be recognized.

6. An apparatus for compressing extensible markup language, comprising:
a means (110) for storing an extensible markup language schema document and associated extensible markup language fragments based on which the extensible markup language schema is compressed,
a means (120) for removing from the extensible markup language schema document of the definition of an element based on the occurrence of the element in the associated extensible markup language fragments.

7. The apparatus for compressing extensible markup language according to claim 6, wherein the means (120) is also for removing from the extensible markup language schema document of the definition of an attribute based on the occurrence of the attribute in the associated extensible markup language fragments.

8. The apparatus for compressing extensible markup language according to claim 7, wherein removing from the extensible markup language schema document of the definition of the element and the attribute when their occurrence frequencies in the associated extensible markup language fragments are less than a predetermined threshold.

9. The apparatus for compressing extensible markup language according to claim 8, wherein the related extensible markup language fragments constitute one or more documents.

10. The apparatus for compressing extensible markup language according to claim 9, wherein it further comprises a means (130) for labeling the compressed extensible markup language schema so that it can be recognized.
